# EUROPEAN PATENT SPECIFICATION

(11) **EP 4 361 670 B1**
(45) Date of publication and mention of the grant of the patent: **02.12.2026**
(21) Application number: 22827906.3
(22) Date of filing: 09.02.2022
(51) Int. Cl.: G01S 7/4861, G01S 7/497, G01S 17/931, G01S 7/481, G01S 7/4863, G01S 7/4865, G01J 5/06, G01J 1/44

(54) **LIGHT-RECEIVING ELEMENT**
LICHTEMPFANGSELEMENT
ÉLÉMENT DE RÉCEPTION DE LUMIÈRE

(30) Priority: 21.06.2021 JP 2021102726
(43) Date of publication of application: 01.05.2024
(73) Proprietor: Sony Semiconductor Solutions Corporation, Atsugi-shi, Kanagawa 243-0014 (JP)
(72) Inventor: KUMAGAI Oichi, Atsugi-shi, Kanagawa 243-0014 (JP); SHINOZUKA Yasuhiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/005069
(87) International publication number: WO 2022/269982

(56) References cited:
- JP-A- 2009 066 257
- JP-A- 2019 039 848
- JP-A- 2019 134 318
- JP-A- 2020 095 016
- JP-A- 2021 090 112
- US-A1- 2018 180 471
- US-A1- 2020 243 413

## Description

### [Technical Field]

The present embodiment relates to a light-receiving element.

### [Background Art]

A SPAD (Single Photon Avalanche Diode) may be used for a vehicle-mounted dToF (direct Time of Flight) ranging sensor. The SPAD is a light-receiving element that operates an avalanche photodiode (APD) in Geiger mode to enable detection of a single photon. In such an SPAD, when a single photon is incident while a reverse bias voltage higher than a breakdown voltage is applied, carriers undergo avalanche multiplication to generate a large current. Based on this current, it is detected that photons have entered the SPAD. PTL 2 describes a light receiver comprising a plurality of avalanche photodiode elements, a first terminal and a second terminal for supplying a bias voltage so that the avalanche photodiode elements are biased with a bias voltage above a breakdown voltage and thus operated in a Geiger mode, at least one temperature measuring element for measuring an operating temperature of the avalanche photodiode elements and a voltage compensation unit for adapting the bias voltage to the operating temperature.

### [Citation List]

### [Patent Literature]

[PTL 1]
   JP 2020-178249A
[PTL 2]
   US 2018/180471 A1

### [Summary]

### [Technical Problem]

Such SPADs generate heat non-uniformly due to photons detected in a pixel region and the corresponding CMOS (Complementary Metal Oxide Semiconductor) circuit, resulting in a temperature gradient. This temperature gradient causes variations in electrical characteristics such as the breakdown voltage of the SPAD, and decreases the photon detective effect (PDE).

Therefore, the present disclosure has been made in view of the above problems, and provides a light-receiving element capable of suppressing variations in electrical characteristics even when there is a temperature gradient.

### [Solution to Problem]

According to a first aspect, the present invention provides a light receiving element according to independent claim 1. According to a second aspect, the present invention provides a ranging system according to claim 13. Further aspects of the present invention are set forth in the dependent claims, the drawings and the following description.
A light-receiving element according to the present embodiment includes a pixel region in which a plurality of photodiodes is arranged; a readout circuit region including a plurality of readout circuits provided corresponding to the plurality of photodiodes, respectively; a first thermometer provided corresponding to a first circuit region of the readout circuit region; a second thermometer provided corresponding to a second circuit region of the readout circuit region; a first control circuit that applies a first voltage corresponding to a temperature of the first circuit region measured by the first thermometer to the photodiode corresponding to the readout circuit in the first circuit region; and a second control circuit that applies a second voltage corresponding to a temperature of the second circuit region measured by the second thermometer to the photodiode corresponding to the readout circuit in the second circuit region.

The readout circuit region has an elongated shape with a long side or a long diameter, and includes the first and second circuit regions arranged along the long side or the long diameter, and the first and second thermometers are arranged corresponding to the first and second circuit regions along the long side or the long diameter.

The light-receiving element further includes a signal processing circuit provided adjacent to one side of the readout circuit region to process pixel signals from the readout circuit region, and the first and second thermometers are provided on a side opposite to the signal processing circuit across the readout circuit region.

The light-receiving element further includes: a first pad connected to the first control circuit; and a second pad connected to the second control circuit, the first thermometer is arranged between the first circuit region and the first pad, and the second thermometer is arranged between the second circuit region and the second pad.

The light-receiving element further includes a first bias circuit provided corresponding to the first circuit region to supply power to a driver of the readout circuit region; and a second bias circuit provided corresponding to the second circuit region to supply power to a driver of the readout circuit region.

The light-receiving element further includes a signal processing circuit provided adjacent to one side of the readout circuit region to process pixel signals from the readout circuit region, and the first and second bias circuits are provided on a side opposite to the signal processing circuit across the readout circuit region.

The light-receiving element further includes a first pad connected to the first control circuit; and a second pad connected to the second control circuit, the first bias circuit is arranged between the first circuit region and the first pad, and the second bias circuit is arranged between the second circuit region and the second pad.

The first bias circuit is arranged close to the first thermometer, and the second bias circuit is arranged close to the second thermometer.

The light-receiving element further includes a first chip including the pixel region; and a second chip including the readout circuit region and bonded to the first chip so that the readout circuits corresponding to the photodiodes face each other.

The pixel region has an elongated shape similar to the readout circuit region, and faces the readout circuit region when the first chip and the second chip are bonded.

The first or second control circuit changes an absolute value of the first or second voltage when a difference between the temperature of the first circuit region and the temperature of the second circuit region exceeds a first threshold.

The first control circuit decreases the absolute value of the first voltage when the temperature of the first circuit region is higher than the temperature of the second circuit region, and the second control circuit decreases the absolute value of the second voltage when the temperature of the second circuit region is higher than the temperature of the first circuit region.

The light-receiving element is mounted on an automobile.

A ranging system according to the present disclosure includes an illumination device that irradiates an object with irradiation light; and a light-receiving element that receives reflected light from the object irradiated with the irradiation light, wherein the light-receiving element includes: a pixel region in which a plurality of photodiodes is arranged; a readout circuit region including a plurality of readout circuits provided corresponding to the plurality of photodiodes, respectively; a first thermometer provided corresponding to a first circuit region of the readout circuit region; a second thermometer provided corresponding to a second circuit region of the readout circuit region; a first control circuit that applies a first voltage corresponding to a temperature of the first circuit region measured by the first thermometer to the photodiode corresponding to the readout circuit in the first circuit region; and a second control circuit that applies a second voltage corresponding to a temperature of the second circuit region measured by the second thermometer to the photodiode corresponding to the readout circuit in the second circuit region.

The illumination device and the light-receiving element are mounted on an automobile.

The pixel region and the readout circuit region each have an elongated shape having a long side or a long diameter, and ranging is performed using the reflected light obtained by scanning a detection target range in a direction of a short side or a short diameter of the elongated shape.

The pixel region and the readout circuit region detect an entire detection target range at once to perform ranging.

The first or second control circuit changes an absolute value of the first or second voltage when a difference between the temperature of the first circuit region and the temperature of the second circuit region exceeds a first threshold.

The first control circuit decreases the absolute value of the first voltage when the temperature of the first circuit region is higher than the temperature of the second circuit region, and the second control circuit decreases the absolute value of the second voltage when the temperature of the second circuit region is higher than the temperature of the first circuit region.

A light-receiving element according to the present disclosure includes a pixel region in which a plurality of photodiodes is arranged; a readout circuit region including a plurality of readout circuits provided corresponding to the plurality of photodiodes, respectively; a signal processing circuit provided adjacent to a first side of the readout circuit region to process pixel signals from the readout circuit region; a first thermometer and a second thermometer provided on a second side opposite to the first side of the readout circuit region, wherein the first thermometer and the second thermometer are provided between a plurality of pads formed at a chip end and the readout circuit region.

### [Brief Description of Drawings]

[Fig. 1]
   Fig. 1 is a block diagram showing a configuration example of an embodiment of a ranging system to which the present technology is applied. [Fig. 2]
Fig. 2 is a block diagram showing a configuration example of an imaging unit.
[Fig. 3]

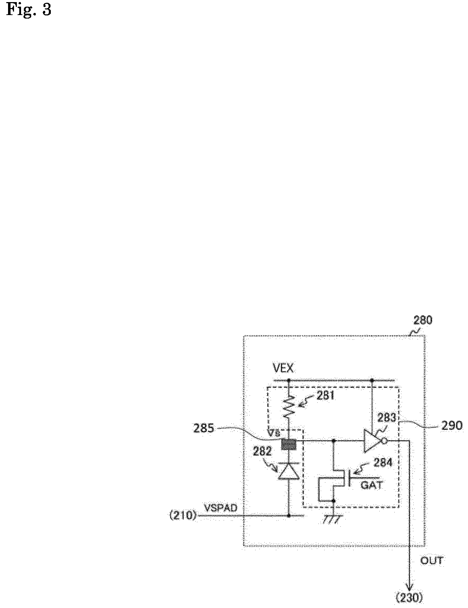

   Fig. 3 is a circuit diagram showing a configuration example of one pixel circuit arranged in a pixel circuit region.
[Fig. 4]

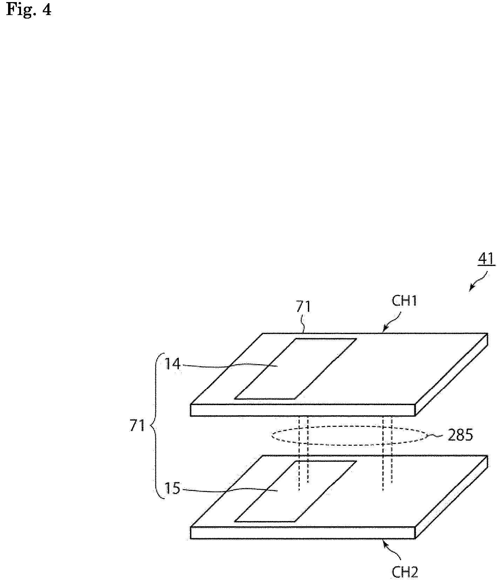

   Fig. 4 is a perspective view showing a configuration example of a light-receiving element including a plurality of stacked semiconductor chips.
[Fig. 5]

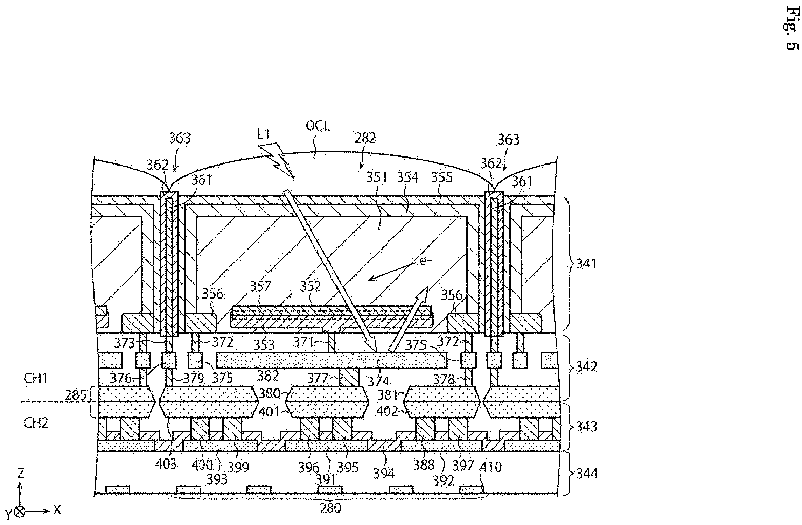

   Fig. 5 is a schematic cross-sectional view showing a configuration example of a pixel circuit.
[Fig. 6A]

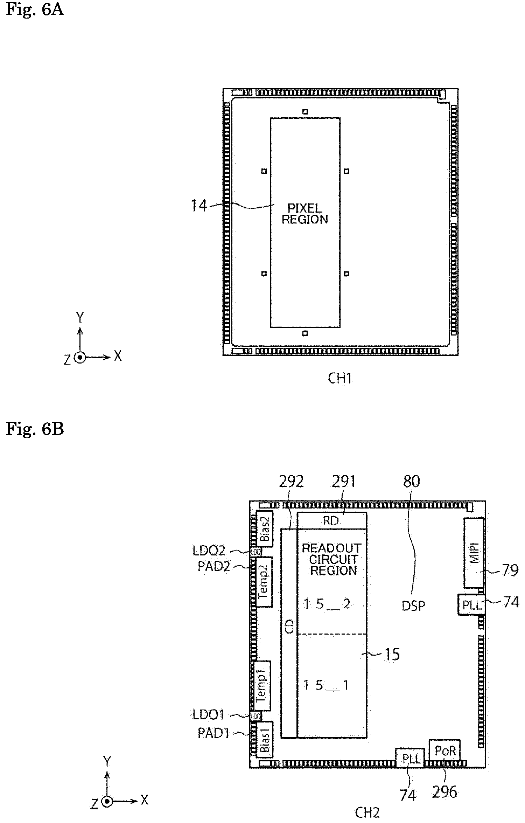

   Fig. 6A is a schematic plan view showing a configuration example of a first chip.
[Fig. 6B]
   Fig. 6B is a schematic plan view showing a configuration example of a second chip.
[Fig. 7]

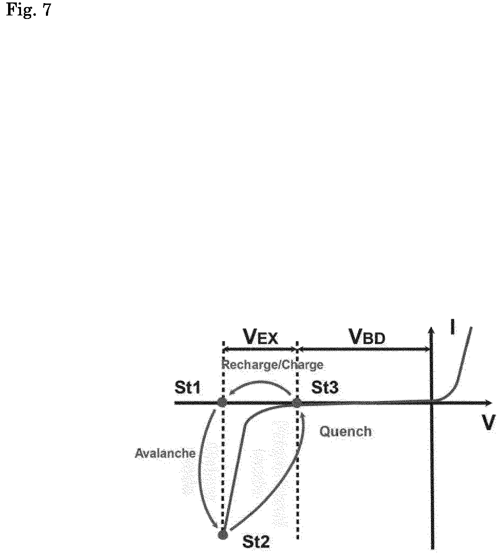

   Fig. 7 is a graph showing an example of the operation of an SPAD according to the present technology.
[Fig. 8]

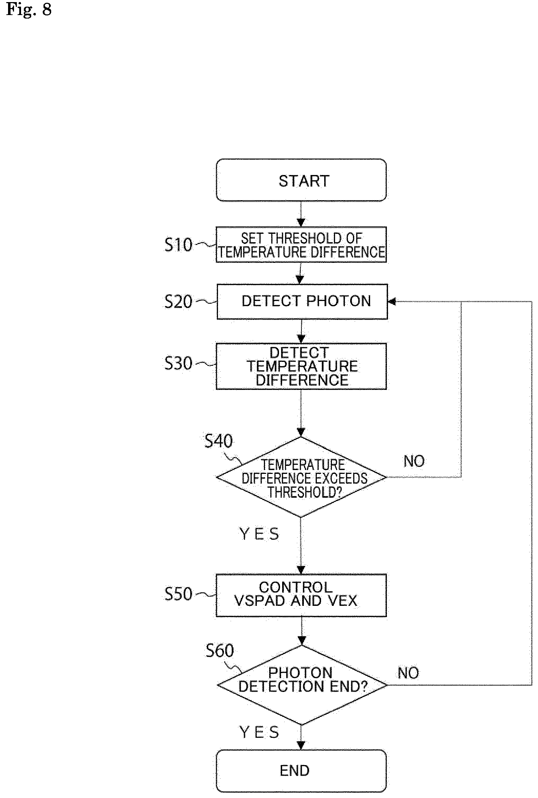

   Fig. 8 is a flowchart showing an example of feedback control operation of a light-receiving element according to the present technology.
[Fig. 9A]

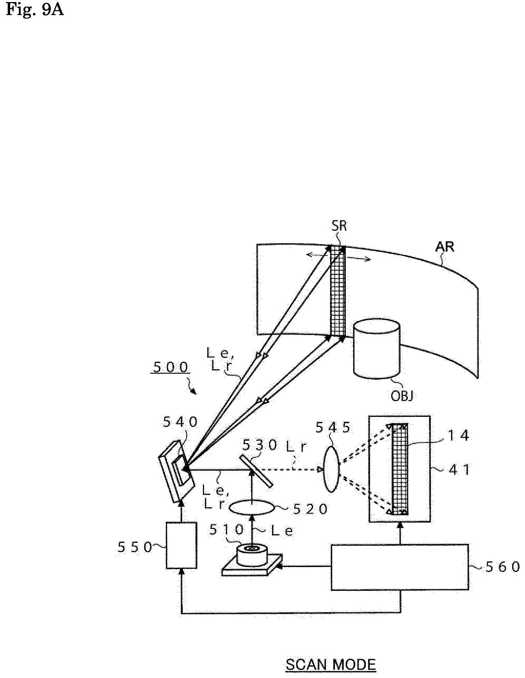

   Fig. 9A is a schematic diagram showing a configuration example of a ranging system operating in a scan mode.
[Fig. 9B]

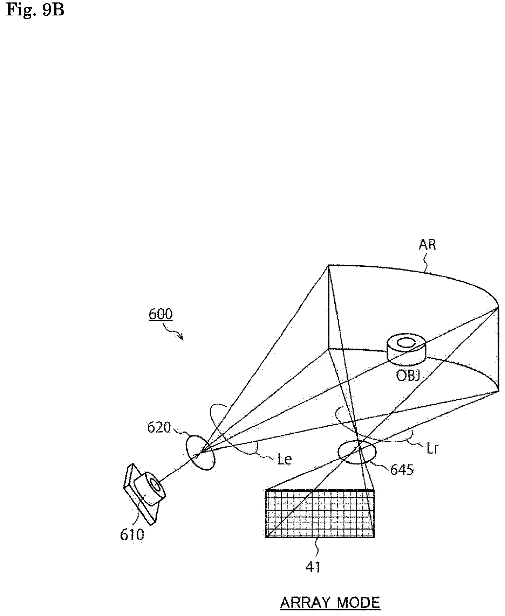

   Fig. 9B is a schematic diagram showing a configuration example of a ranging system operating in an array mode.
[Fig. 10]

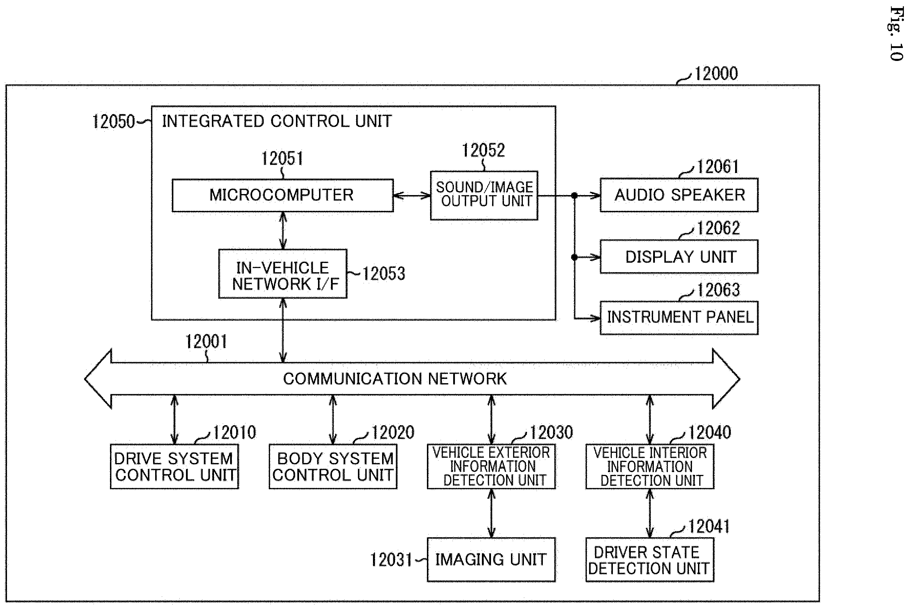

   Fig. 10 is a block diagram showing a schematic configuration example of a vehicle control system that is an example of a mobile control system to which the technology according to the present disclosure can be applied.
[Fig. 11]

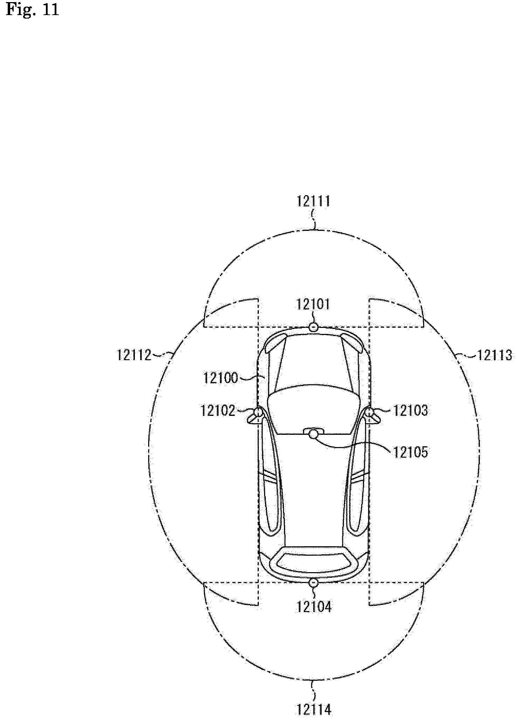

   Fig. 11 is a diagram showing an example of an installation position of an imaging unit.

### [Description of Embodiments]

Hereinafter, embodiments according to the present invention will be described with reference to the drawings. The present embodiment does not limit the present invention. The drawings are schematic or conceptual, and the ratio and the like of each part are not necessarily the same as the actual one. In the specification and drawings, the same reference numerals are given to the same elements as those described above with respect to the previous drawings, and detailed description thereof will be omitted as appropriate.

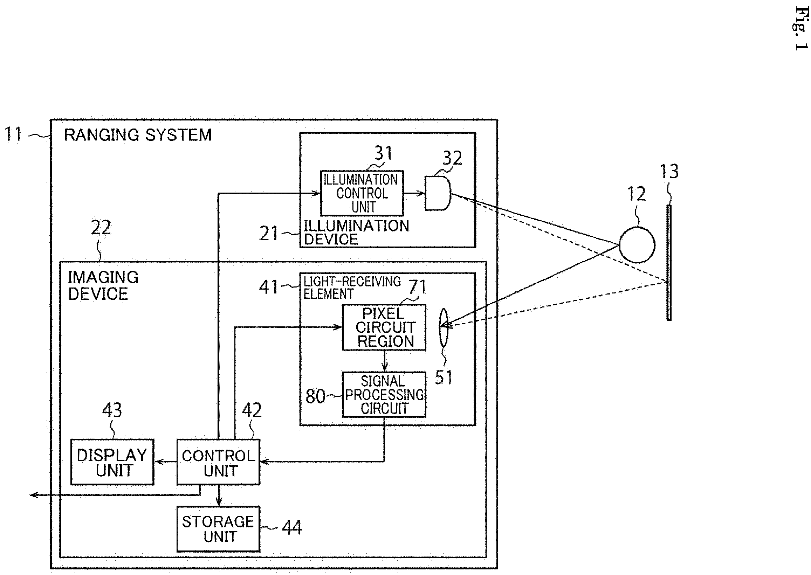

Fig. 1 is a block diagram showing a configuration example of an embodiment of a ranging system to which the present technology is applied. A ranging system 11 is a system that takes a distance image using, for example, the ToF method. Here, the distance image is an image composed of distance pixel signals based on the distance obtained by detecting the distance in the depth direction from the ranging system 11 to the subject for each pixel.

The ranging system 11 includes an illumination device 21 and an imaging device 22. The illumination device 21 includes an illumination control unit 31 and a light source 32. The illumination control unit 31 controls the pattern in which the light source 32 emits light under the control of a control unit 42 of the imaging device 22. Specifically, the illumination control unit 31 controls the pattern in which the light source 32 emits light according to an irradiation code included in the irradiation signal supplied from the control unit 42. For example, the irradiation code consists of two values of 1 (High) and 0 (Low). The illumination control unit 31 turns on the light source 32 when the value of the irradiation code is 1, and turns off the light source 32 when the value of the irradiation code is 0.

The light source 32 emits light in a predetermined wavelength range under the control of the illumination control unit 31. The light source 32 is configured of an infrared laser diode, for example. Note that the type of the light source 32 and the wavelength range of the irradiation light can be arbitrarily set depending on the application of the ranging system 11 and the like.

The imaging device 22 is a device that receives light (irradiation light) emitted from the illumination device 21 and reflected by a subject 12, a subject 13, and the like. The imaging device 22 includes a light-receiving element 41, a control unit 42, a display unit 43 and a storage unit 44.

The light-receiving element 41 includes a lens 51, a pixel circuit region 71 and a signal processing circuit 80. The lens 51 forms an image of incident light on the light-receiving surface of the pixel circuit region 71. The configuration of the lens 51 is arbitrary, and for example, the lens 51 can be configured by a plurality of lens groups. The pixel circuit region 71 is configured by two-dimensionally arranging a plurality of pixel circuits in a matrix. Each pixel includes, for example, one SPAD and a readout circuit provided corresponding to the SPAD. When SPADs are miniaturized, one readout circuit may be commonly provided for a plurality of SPADs.

The pixel circuit region 71 receives reflected light from the subject 12, the subject 13, and the like under the control of the control unit 42, and supplies the resulting pixel signal to the signal processing circuit 80. This pixel signal represents a digital count value obtained by counting the time from when the illumination device 21 emits the irradiation light to when the pixel circuit region 71 receives the light. An emission timing signal indicating the timing at which the light source 32 emits light is also supplied from the control unit 42 to the pixel circuit region 71.

The signal processing circuit 80 processes pixel signals supplied from the pixel circuit region 71 under the control of the control unit 42. For example, the signal processing circuit 80 detects the distance to the subject for each pixel based on the pixel signal supplied from the pixel circuit region 71, and generates a distance image indicating the distance to the subject for each pixel. Specifically, the signal processing circuit 80 acquires the time (count value) from when the light source 32 emits light to when each pixel in the pixel circuit region 71 receives light a plurality of times (for example, several thousand times to several tens of thousands of times) for each pixel. The signal processing circuit 80 creates a histogram corresponding to the acquired time. By detecting the peak of the histogram, the signal processing circuit 80 determines the time until the light emitted from the light source 32 is reflected by the subject 12 or 13 and returns. Further, the signal processing circuit 80 performs calculations for obtaining the distance to the object based on the determined time and the speed of light. The signal processing circuit 80 supplies the generated distance image to the control unit 42.

The control unit 42 is configured by, for example, a control circuit such as an FPGA (Field Programmable Gate Array) or a DSP (Digital Signal Processor), a processor, or the like. The control unit 42 controls the illumination control unit 31 and the light-receiving element 41. Specifically, the control unit 42 supplies an irradiation signal to the illumination control unit 31 and an emission timing signal to the light-receiving element 41. The light source 32 emits irradiation light according to the irradiation signal. The emission timing signal may be an irradiation signal supplied to the illumination control unit 31. Further, the control unit 42 supplies the distance image acquired from the light-receiving element 41 to the display unit 43 and causes the display unit 43 to display the distance image. Furthermore, the control unit 42 causes the storage unit 44 to store the distance image acquired from the light-receiving element 41. In addition, the control unit 42 outputs the distance image acquired from the light-receiving element 41 to the outside. The display unit 43 is, for example, a panel-type display device such as a liquid crystal display device or an organic EL (Electro Luminescence) display device.

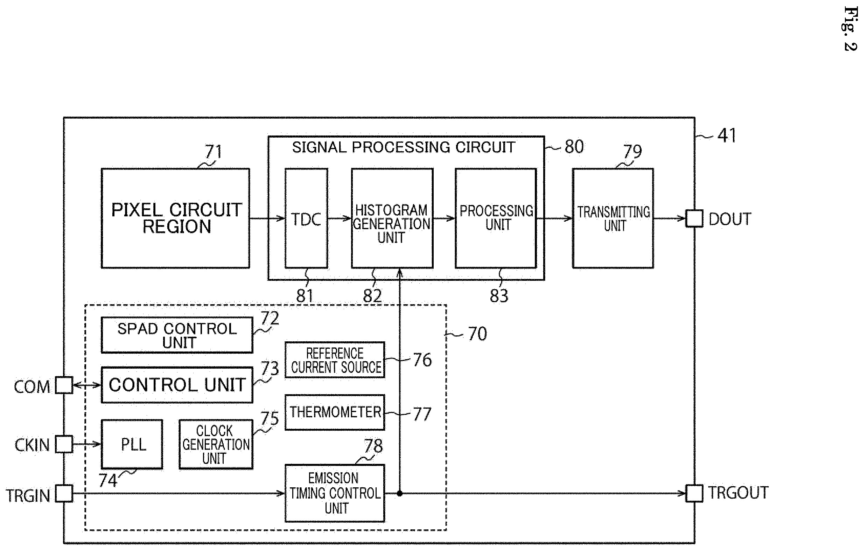

Fig. 2 is a block diagram showing a configuration example of the light-receiving element 41. The light-receiving element 41 includes a pixel circuit region 71, a peripheral circuit 70, a signal processing circuit 80 and a transmitting unit 79. The peripheral circuit 70 includes a SPAD control unit 72, a control unit 73, a PLL (Phase Locked Loop) 74, a clock generation unit 75, a reference current source 76, a thermometer 77, and an emission timing control unit 78.

As described above, the pixel circuit region 71 includes a plurality of SPADs arranged two-dimensionally in a matrix and a readout circuit provided corresponding to each SPAD. A more detailed configuration of the pixel circuit region 71 will be described later.

The SPAD control unit 72 controls the operation of the pixel circuit region 71 based on instructions from the control unit 73. The control unit 73 controls each component of the light-receiving element 41. The control unit 73 also has a function of communicating with an external device using, for example, I2C via a terminal COM. The PLL 74 operates based on the input clock supplied via a terminal CKIN. The clock generation unit 75 generates one or more clock signals to be used in the light-receiving element 41. The reference current source 76 generates one or more reference currents to be used in light-receiving element 41. The thermometer 77 detects the temperature in the light-receiving element 41. The emission timing control unit 78 controls the emission timing based on an emission trigger signal supplied via a terminal TRGIN. The emission timing control unit 78 generates an emission trigger signal, supplies the emission trigger signal to the signal processing circuit 80, and outputs the emission trigger signal via a terminal TRGOUT. The signal processing circuit 80 generates a depth image based on the detection result in the pixel circuit region 71. Control signals input through the terminals COM, CKIN, and TRGIN are supplied from the control unit 42 of Fig. 1. Signals output via the terminals DOUT and TRGOUT are output to the control unit 42.

The signal processing circuit 80 has a TDC (Time to Digital Converter) 81, a histogram generation unit 82 and a processing unit 83. The TDC 81 converts the light reception timing into a digital value based on the detection result in the pixel circuit region 71. The histogram generation unit 82 generates a histogram based on the digital value obtained by the TDC 81. The processing unit 83 performs various processes based on the histogram generated by the histogram generation unit 82. For example, the processing unit 83 performs FIR (Finite Impulse Response) filter processing, echo determination, depth value (distance value) calculation processing, peak detection processing, and the like.

The transmitting unit 79 outputs the depth image generated by the signal processing circuit 80 as serial data, for example, via the terminal DOUT. For example, an MIPI (Mobile Industry Processor Interface) can be used as the interface of the transmitting unit 79.

Fig. 3 is a circuit diagram showing a configuration example of one pixel circuit 280 arranged in the pixel circuit region 71. The pixel circuit 280 includes a resistance element 281, a SPAD 282, an inverter circuit 283 and a transistor 284. The resistance element 281, the inverter circuit 283, and the transistor 284 other than the SPAD 282 are hereinafter also referred to as a readout circuit 290.

The cathode of the SPAD 282 is connected to one end of the resistance element 281 via a bonding portion 285 and to the power supply line of an excess bias voltage VEX via the resistance element 281. In addition, the cathode of the SPAD 282 is connected to the input terminal of the inverter circuit 283 and the drain of the transistor 284. The anode of the SPAD 282 is connected to the power line of a bias voltage VSPAD.

The SPAD 282 waits for the incidence of photons in a state where a reverse bias above the breakdown voltage VBD is applied. When photons enter the SPAD 282, electrons generated by photoelectric conversion by avalanche multiplication are amplified in the SPAD 282. The current flowing at once due to this avalanche breakdown changes the cathode voltage Vs of the SPAD 282 and inverts the output signal of the inverter circuit 283. Thus, the SPAD 282 can detect the incidence of a single photon. The electron multiplication operation starting from the arrival time of photons is called Geiger mode.

One end of the resistance element 281 is connected to the power supply line of the excess bias voltage VEX. The other end of the resistance element 281 is connected to the cathode of the SPAD 282, the input terminal of the inverter circuit 283, and the drain of the transistor 284. In this way, the cathode of the SPAD 282 can be supplied with the excess bias voltage VEX through the resistance element 281. The resistance element 281 decreases the cathode voltage Vs when the SPAD 282 undergoes avalanche breakdown. Incidentally, the resistance element 281 may be a quenching resistance configured of a P-type MOSFET operating in the saturation region.

The drain of the transistor 284 is connected to the cathode of the SPAD 282, the input terminal of the inverter circuit 283, and the resistance element 281. The source of the transistor 284 is connected to the ground (GND). The gate of the transistor 284 is supplied with a gating control signal GAT from the control unit 42 of Fig. 1. The transistor 284 is configured of, for example, an N-type MOSFET.

In the Geiger mode, the bias voltage VSPAD is approximately equal to the breakdown voltage VBD of the SPAD 282, for example, a negative bias voltage of -20V. The excess bias voltage VEX is the voltage added to the breakdown voltage VBD to allow the SPAD 282 to detect photons. The excess bias voltage VEX is, for example, a positive bias voltage of +3V. Thus, in the Geiger-mode charge operation or recharge operation, the SPAD 282 is applied with a reverse bias voltage corresponding to the sum (| VBD | + | VEX |) of the absolute value of VBD and the absolute value of VEX. |VBD| + |VEX| is, for example, 23 V. The bias voltage VSPAD and the excess bias voltage VEX may be supplied from the SPAD control unit 72.

Fig. 4 is a perspective view showing a configuration example of a light-receiving element 41 including a plurality of stacked semiconductor chips. As shown in Fig. 4, the light-receiving element 41 is configured by stacking two semiconductor chips CH1 and CH2. A pixel region 14 is provided in the first chip CH1. The pixel region 14 is a region in which a plurality of SPADs 282 are two-dimensionally arranged in a matrix on a semiconductor substrate. A readout circuit region 15 is provided in the second chip CH2. The readout circuit region 15 is a region in which a plurality of readout circuits 290 are two-dimensionally arranged in a matrix on the semiconductor substrate.

The readout circuit region 15 has substantially the same size and shape as the pixel region 14, and the two regions face and contact each other when the first chip CH1 and the second chip CH2 are stacked. Although the first chip CH1 and the second chip CH2 are separated from each other in Fig. 4, the two chips are stacked on each other in the finished product of the light-receiving element 41.

The readout circuits 290 in the readout circuit region 15 correspond to and face the SPADs 282 in the pixel region 14, and are electrically connected via the bonding portions 285. For example, as shown in Fig. 3, in the pixel circuit 280, the readout circuit 290 corresponds to the SPAD 282 on a one-to-one basis and is electrically connected to the SPAD 282 at the bonding portion 285. The bonding portion 285 connects the cathode of the SPAD 282 on the first chip CH1 side to the resistance element 281, the inverter circuit 283, and the transistor 284 on the second chip CH2 side by directly bonding the wirings exposed on the surfaces of the chips CH1 and CH2. In this way, the first chip CH1 and the second chip CH2 are directly bonded to each other by wiring (Cu-Cu bonding) with the readout circuit 290 and the SPAD 282 facing each other, so that the SPAD 282 and the corresponding readout circuit 290 are electrically connected. The pixel circuit region 71 is configured by electrically bonding the pixel region 14 and the readout circuit region 15 through the bonding portion 285.

Although not shown, the light-receiving element 41 may be configured of one semiconductor chip. In this case, the pixel circuit region 71, the signal processing circuit 80, the transmitting unit 79, and the peripheral circuit 70 are formed in a flat state on the surface of one semiconductor chip.

Fig. 5 is a schematic cross-sectional view showing a configuration example of the pixel circuit 280. The light-receiving element 41 according to the present embodiment is configured of a first chip CH1 and a second chip CH2 that are stacked. In the first chip CH1, a sensor substrate 341, a sensor wiring layer 342, a logic wiring layer 343, and a logic circuit board 344 are stacked.

The sensor substrate 341 is, for example, a semiconductor substrate using single crystal silicon containing p-type or n-type impurities. The SPAD 282 is provided for each pixel circuit 280 on the sensor substrate 341. In Fig. 5, the surface of the sensor substrate 341 is the light-receiving surface for receiving the light L1, and the sensor wiring layer 342 is provided on the back side opposite to the light-receiving surface. In addition, on the back side of the sensor substrate 341, the second chip CH2 is bonded to the first chip CH1.

In the sensor wiring layer 342 and the logic wiring layer 343, wirings (power supply lines) for supplying the bias voltages VSPAD and VEX to be applied to the SPAD 282, or wirings for extracting electrons generated in the SPAD 282 from the sensor substrate 341, and the like are provided.

The SPAD 282 is provided on the sensor substrate 341. The SPAD 282 includes an n-type well 351, a p-type diffusion layer 352, an n-type diffusion layer 353, a hole accumulation layer 354, a pinning layer 355 and a heavily doped p-type diffusion layer 356. The SPAD 282 generates a depletion layer by applying a reverse bias to the pn junction between the p-type diffusion layer 352 and the n-type diffusion layer 353. Photons entering this depletion layer cause the SPAD 282 to undergo an avalanche breakdown. That is, the depletion layer at the pn junction between the p-type diffusion layer 352 and the n-type diffusion layer 353 functions as an avalanche multiplication region 357.

The n-type diffusion layer 353 is electrically connected to a contact 371 that provides the bias voltage VSPAD to form the avalanche multiplication region 357. That is, the cathode of the SPAD 282 is electrically connected to the contact 371. The p-type diffusion layer 352 is electrically connected through a well 351 to the heavily doped p-type diffusion layer 356 supplying the bias voltage VEX and the contact 372 to form the avalanche multiplication region 357. That is, the anode of the SPAD 282 is electrically connected to the contact 372.

The hole accumulation layer 354 is a p-type diffusion layer covering the side and bottom surfaces of the well 351 and accumulates holes. The hole accumulation layer 354 is also electrically connected to the contact 372 (anode of the SPAD 282) to allow bias adjustment. As a result, the hole concentration in the hole accumulation layer 354 is enhanced, and the pinning including the pinning layer 355 is strengthened, thereby suppressing the occurrence of dark current, for example.

The pinning layer 355 is a heavily doped p-type diffusion layer (p+) formed on the surface outside the hole accumulation layer 354 (the side surface in contact with the back surface of the sensor substrate 341 and the insulating film 362), and suppresses the generation of dark current similarly to the hole accumulation layer 354.

The heavily doped p-type diffusion layer 356 is a heavily doped p-type diffusion layer (p++) formed so as to surround the periphery of the well 351 near the surface of the sensor substrate 341, and is used for connection to the contact 372 for electrically connecting the hole accumulation layer 354 to the anode of the SPAD 282.

The avalanche multiplication region 357 is a depletion layer region caused by a reverse bias voltage applied to the pn junction between the n-type diffusion layer 353 and the p-type diffusion layer 352. The avalanche multiplication region 357 avalanche-breaks down with one photon incident on the SPAD 282 and avalanche-multiplies electrons (e-).

Further, an inter-pixel separating portion 363 with a double-structure of a metal film 361 and an insulating film 362 is provided between adjacent SPADs 282. The adjacent SPADs 282 are insulated and separated by the inter-pixel separating portion 363. The inter-pixel separating portion 363 is formed so as to penetrate from the back surface to the front surface of the sensor substrate 341. That is, the inter-pixel separating portion 363 has a full trench isolation structure.

The metal film 361 is formed of a metal (for example, tungsten) that reflects light. The insulating film 362 is formed of an insulating film such as a silicon oxide film. For example, the inter-pixel separating portion 363 is formed by embedding the metal film 361 in the sensor substrate 341 so that the surface of the metal film 361 is covered with the insulating film 362. The inter-pixel separating portion 363 electrically and optically separates the adjacent SPADs 282.

The sensor wiring layer 342 is provided with contacts 371 to 373, metal wirings 374 to 376, contacts 377 to 379, and metal pads 380 to 382.

The contact 371 connects between the n-type diffusion layer 353 and the metal wiring 374. The contact 372 connects between the heavily doped p-type diffusion layer 356 and the metal wiring 375. The contact 373 connects between the metal film 361 and the metal wiring 376.

The metal wiring 374 is formed wider than the avalanche multiplication region 357 so as to cover at least the avalanche multiplication region 357, for example. As a result, the metal wiring 374 reflects the light transmitted through the SPAD 282 to the SPAD 282. This leads to improved photon detective effect (PDE).

The metal wiring 375 is provided, for example, so as to surround the periphery of the metal wiring 374, and overlaps the heavily doped p-type diffusion layer 356 in plan view from the incident direction (Z direction) of the light L1. The metal wiring 376 is provided, for example, at four corners of the SPAD 282 and connected to the metal film 361.

The contact 377 connects between the metal wiring 374 and the metal pad 380. The contact 378 connects between the metal wiring 375 and the metal pad 381. The contact 379 connects between the metal wiring 376 and the metal pad 382.

The metal pads 380 to 382 are bonded to the metal pads 401 to 403 provided on the logic wiring layer 343. The metal pads 380 to 382 and the metal pads 401 to 403 are formed of metal such as copper, and are electrically connected to each other by being electrically and mechanically bonded (Cu-Cu bonding). The metal pads 380 to 382 and the metal pads 401 to 403 bonded in this manner function as the bonding portion 285 in Fig. 3.

The logic wiring layer 343 is provided with electrode pads 391 to 393, an insulating layer 394, contacts 395 to 400, and metal pads 401 to 403.

The electrode pads 391 to 393 are used for connection with the logic circuit board 344 respectively. The insulating layer 394 insulates the electrode pads 391 to 393 from each other.

The contacts 395 and 396 connect between the electrode pad 391 and the metal pad 401. The contacts 397 and 398 connect between the electrode pad 392 and the metal pad 402. The contacts 399 and 400 connect between the electrode pad 393 and the metal pad 403.

The metal pad 401 is bonded to the metal pad 380, the metal pad 402 is bonded to the metal pad 381, and the metal pad 303 is bonded to the metal pad 382.

With such a wiring structure, the electrode pad 391 is connected to the n-type diffusion layer 353 via the contacts 395 and 396, the metal pads 401 and 380, the contact 377, the metal wiring 374 and the contact 371. Therefore, in the SPAD 282, when the bias voltage VSPAD is applied from the logic circuit 410 of the logic circuit board 344 to the electrode pad 391, it is applied to the n-type diffusion layer 353 via the metal pads 401 and 380 and the like.

In addition, the electrode pad 392 is connected to the heavily doped p-type diffusion layer 356 via the contacts 397 and 398, the metal pads 402 and 381, the contact 378, the metal wiring 375 and the contact 372. Therefore, in the SPAD 282, when the bias voltage VEX is applied from the logic circuit 410 of the logic circuit board 344 to the electrode pad 392, it is applied to the heavily doped p-type diffusion layer 356 via the metal pads 402 and 381 and the like. Thus, the logic circuit 410 of the logic circuit board 344 can apply the bias voltages VSPAD and VEX to the anode (p-type diffusion layer 352) and cathode (n-type diffusion layer 353) of the SPAD 282, respectively.

Furthermore, the electrode pad 393 is connected to the metal film 361 via the contacts 399 and 400, the metal pads 403 and 382, the contact 379, the metal wiring 376 and the contact 373. Accordingly, in the SPAD 282, the bias voltage supplied from the logic circuit board 344 to the electrode pad 393 is applied to the metal film 361.

A logic circuit 410 is provided on the logic circuit board 344. The logic circuit board 344 is, for example, a semiconductor substrate using single crystal silicon containing p-type or n-type impurities. The logic circuit board 344 is provided on the back side of the sensor substrate 341. The logic circuit 410 includes a bias voltage application circuit that applies the bias voltages VSPAD and VEX to the SPAD 282 or the readout circuit 290.

In plan view in the Z direction, the metal wiring 374 is formed wider than the avalanche multiplication region 357 so as to cover the avalanche multiplication region 357. Further, the metal film 361 is formed so as to penetrate the sensor substrate 341. That is, the SPAD 282 is formed so as to have a reflecting structure in which the metal wiring 374 and the metal film 361 surround the SPAD 282 except for the light incident surface. By reflecting the light L1 by the metal wiring 374 and the metal film 361, optical crosstalk can be suppressed and the photon detective effect (PDE) can be improved. In addition, the metal wiring 374 can suppress the light L1 from entering the logic circuit 410 and suppress noise contained in the pixel signal of the logic circuit 410 and malfunction of the logic circuit 410.

An on-chip lens OCL is provided on the surface (incident light) side of the sensor substrate 341. The on-chip lens OCL is provided to condense the incident light L1 onto the avalanche multiplication region 357. The on-chip lens OCL is formed using, for example, a transparent resin material.

Fig. 6Ais a schematic plan view showing a configuration example of the first chip CH1. The first chip CH1 includes a pixel region 14 provided on a semiconductor substrate. The pixel region 14 is configured by two-dimensionally arranging a plurality of photodiodes (282 in Fig. 3) in a matrix.

Fig. 6B is a schematic plan view showing a configuration example of the second chip CH2. The second chip CH2 includes a readout circuit region 15, a row driver 291, a column driver 292, a signal processing circuit (DSP) 80, a PLL 74, a transmitting unit 79, a PoR (Power on Reset) circuit 296, a plurality of thermometers Temp 1 and Temp2, a plurality of bias circuits Bias1 and Bias2, and a plurality of bias control circuits LDO1 and LDO2 (LDO: Low Drop Out) on the semiconductor substrate.

The readout circuit region 15 is configured by two-dimensionally arranging a plurality of readout circuits (290 in Fig. 3) in a matrix. The readout circuit 290 is provided corresponding to each of the SPADs 282 in the pixel region 14.

The row driver 291 and the column driver 292 select an arbitrary pixel circuit 280 in the pixel circuit region 71 and output a pixel signal from the readout circuit 290 of the selected pixel circuit 280 to the signal processing circuit 80. The row driver 291 and the column driver 292 are configured by logic circuits and controlled by control signals from the SPAD control unit 72 in Fig. 2.

The signal processing circuit 80 is configured to process the pixel signal from the readout circuit 290, and is configured by, for example, a control circuit such as FPGA or DSP, or a processor. The function of the signal processing circuit 80 is as described with reference to Fig. 2.

The transmitting unit 79 outputs the image signal processed by the signal processing circuit 80 to the outside of the light-receiving element 41 according to the timing of the PLL 74. For example, an MIPI is used for the transmitting unit 79 as described above. The PoR circuit 296 is a circuit that activates the light-receiving element 41 according to the timing of the PLL 74.

In the present disclosure, a plurality of thermometers Temp1 and Temp2 are provided near the readout circuit region 15. The thermometer Temp1 as a first thermometer is provided corresponding to a circuit region 15_1 as a first circuit region in the readout circuit region 15. The thermometer Temp2 as a second thermometer is provided corresponding to a circuit region 15_2 as a second circuit region in the readout circuit region 15.

The pixel region 14 and the readout circuit region 15 have an elongated shape with a long side or a long diameter in plan view from the incident direction (Z direction) of the light L1, and are approximately rectangular as shown in Figs. 6A and 6B. The pixel region 14 has an elongated shape similar to the readout circuit region 15, and faces the readout circuit region 15 when the first chip CH1 and the second chip CH2 are bonded. As a result, each SPAD 282 in the pixel region 14 corresponds to each readout circuit 290 in the readout circuit region 15 and can be electrically connected to its corresponding readout circuit 290 via the bonding portion 285. The pixel region 14 and the readout circuit region 15 may have a substantially elliptical shape with a long diameter or other elongated shapes.

The thermometers Temp1 and Temp2 are arranged in parallel along the long side or the long diameter of the readout circuit region 15 having such an elongated shape, and are provided corresponding to the circuit regions 15_1 and 15_2, respectively. By arranging the thermometer Temp1 corresponding to and adjacent to the circuit region 15_1, the thermometer Temp1 can measure the temperature of the circuit region 15_1. By arranging the thermometer Temp2 corresponding to and adjacent to the circuit region 15_2, the thermometer Temp2 can measure the temperature of the circuit region 15_2. As a result, the temperature distribution of the readout circuit region 15 can be known. The temperature distribution of the readout circuit region 15 is used for feedback control of the bias voltages VSPAD and BEX. Details of the feedback control of the bias voltages VSPAD and BEX will be described later.

The signal processing circuit 80 is also provided adjacent to one side of the readout circuit region 15. However, the thermometers Temp1 and Temp2 are provided on a side opposite to the signal processing circuit 80 across the readout circuit region 15. That is, the signal processing circuit 80 is arranged on one side of the readout circuit region 15 and the thermometers Temp1 and Temp2 are arranged on the other side of the readout circuit region 15. As a result, the thermometers Temp1 and Temp2 are arranged near the bias control circuits LDO1 and LDO2 included in an input/output circuit. Thus, wire connection between the thermometer Temp 1 and the bias control circuit LDO1 and wire connection between the thermometer Temp2 and the bias control circuit LDO2 are facilitated. Further, it is not necessary to arrange the thermometers Temp 1 and Temp2 between the readout circuit region 15 and the signal processing circuit 80. Thus, wiring connection between the readout circuit region 15 and the signal processing circuit 80 is facilitated.

The bias control circuit LDO1 as a first control circuit is a regulator circuit provided in an input/output circuit near the thermometer Temp1. The bias control circuit LDO1 is connected to a power input pad PAD1 and externally receives the bias voltages VSPAD and VEX from the pad PAD1. The bias control circuit LDO1 controls the bias voltages VSPAD and VEX and supplies the voltages to the SPAD282 corresponding to the circuit region 15_1.

In addition, the bias control circuit LDO1 applies the bias voltages VSPAD and BEX corresponding to the temperature of the circuit region 15_1 measured by the thermometer Temp1 to the SPAD 282 corresponding to the readout circuit 290 in the circuit region 15_1. As a result, the bias control circuit LDO1 can feedback-control the bias voltages VSPAD and VEX applied to the SPAD 282 corresponding to the circuit region 15_1 according to the temperature of the circuit region 15_1. Since the thermometer Temp1 is arranged close to the bias control circuit LDO1, delay in feedback control can be suppressed.

The bias control circuit LDO2 as a second control circuit is a regulator circuit provided in an input/output circuit near the thermometer Temp2. The bias control circuit LDO2 is connected to a power input pad PAD2 and externally receives the bias voltages VSPAD and VEX from the pad PAD2. The bias control circuit LDO2 controls the bias voltages VSPAD and VEX and supplies the voltages to the SPAD 282 corresponding to the circuit region 15_2.

The bias control circuit LDO2 also applies bias voltages VSPAD and BEX corresponding to the temperature of the circuit region 15_2 measured by the thermometer Temp2 to the SPAD 282 corresponding to the readout circuit 290 in the circuit region 15_2. As a result, the bias control circuit LDO1 can feedback-control the bias voltages VSPAD and BEX applied to the SPAD 282 corresponding to the circuit region 15_2 according to the temperature of the circuit region 15_2. Since the thermometer Temp2 is arranged close to the bias control circuit LDO2, delay in feedback control can be suppressed.

The bias control circuits LDO1 and LDO2 can apply synchronized but different bias voltages VSPAD and VEX to the circuit regions 15_1 and 15_2, respectively.

Here, the power input pads PAD1 and PAD2 are, for example, part of a plurality of pads provided at the chip edge of the second chip CH2. A plurality of pads are provided on the four sides of the chip and are used for input/output of signals with the outside and input/output of signals for inspecting the chips. The power input pads PAD1 and PAD2 may be included in a plurality of pad groups provided on one side of the chip.

The thermometers Temp1 and Temp2 are arranged near the bias control circuits LDO1 and LDO2. The thermometer Temp 1 is arranged between the readout circuit region 15 and the pad PAD1, and the thermometer Temp2 is arranged between the readout circuit region 15 and the pad PAD2. As a result, the thermometers Temp1 and Temp2 can quickly feed back the respective temperatures of the circuit regions 15_1 and 15_2 to the bias control circuits LDO1 and LDO2, respectively.

Furthermore, in the present technology, the plurality of bias circuits Bias1 and Bias2 are provided. The bias circuit Bias1 as a first bias circuit supplies power to the row driver 291, the column driver 292, the thermometers Temp1 and Temp2, and the like in the readout circuit region 15. The bias circuit Bias2 as a second bias circuit also supplies power to the row driver 291, the column driver 292, the thermometers Temp 1 and Temp2, and the like in the readout circuit region 15. By providing the plurality of bias circuits Bias1 and Bias2 in one second chip CH2, even if one of the bias circuits Bias1 and Bias2 fails, the other can supply power to the second chip CH2. That is, the plurality of bias circuits Bias1 and Bias2 can ensure redundancy of power supply to the second chip CH2 and robustness against power failure can be ensured.

The bias circuits Bias1 and Bias2 are also provided on a side opposite to the signal processing circuit 80 across the readout circuit region 15. For example, the bias circuit Bias1 is provided between the circuit region 15_1 and the pad PAD1 and arranged near the thermometer Temp1. The bias circuit Bias2 is provided between the circuit region 15_2 and the pad PAD2 and arranged near the thermometer Temp2.

Next, the operation of the light-receiving element 41 will be described.

Fig. 7 is a graph illustrating an example of the operation of the SPAD 282 according to the present technology. Fig. 7 shows the operation of one SPAD 282. The vertical axis of the graph is the current I flowing through one SPAD 282 and the horizontal axis is the voltage V applied to that SPAD 282.

In the Geiger mode, the voltage V applied to the SPAD 282 is a reverse bias voltage corresponding to the sum of the anode-side bias voltage VSPAD and the cathode-side bias voltage VEX of the SPAD 282 in Fig. 3. For example, if the bias voltage VSPAD is equal to the breakdown voltage VBD of the SPAD 282, a reverse bias voltage corresponding to the sum (| VBD | + | VEX |) of the absolute value of VBD and the absolute value of VEX is applied to the SPAD 282 as the voltage V. That is, the SPAD 282 is applied and charged with a reverse bias voltage that exceeds the breakdown voltage VBD by the excess bias voltage VEX.

The SPAD 282 is charged to the reverse bias voltage of ( | VBD | + | VEX | ) in the dark state. At this time, since the SPAD 282 is in the dark state in which no photons are incident, an avalanche breakdown does not occur in the SPAD 282, and the SPAD 282 is maintained in the first state St1. At this time, almost no current I flows through the SPAD 282.

Next, when photons of the light L1 enter the SPAD 282, an avalanche breakdown occurs in the avalanche multiplication region 357, and the current I due to the avalanche multiplication flows at once. As a result, the SPAD 282 enters the second state St2.

Avalanche multiplication stops when the voltage (reverse bias voltage) V applied to the SPAD 282 drops to the breakdown voltage VBD due to the flow of current I. That is, the SPAD 282 enters the third state St3. An operation in which electrons generated by avalanche multiplication are discharged from the SPAD 282 and the voltage V returns to the breakdown voltage is also called a quenching operation.

After the quenching operation, when the excess bias voltage VEX is applied to the SPAD 282 again, the SPAD 282 is recharged to return to the first state St1 and becomes ready to detect photons.

In this way, the SPAD 282 repeatedly performs the recharge operation, the photon avalanche multiplication operation, the quenching operation, the recharge operation, and so on, and the first to third states St1, St2, and St3. As a result, the SPAD 282 causes a large current I to flow each time it detects a photon, thereby decreasing the cathode voltage Vs in Fig. 3. As a result, the logic of the output signal 230 of the inverter circuit 283 is inverted each time the SPAD 282 detects a photon.

By counting the inversions of the output signal 230, the signal processing circuit 80 of Fig. 3 can perform subsequent signal processing, such as generating a histogram. As a result, the signal processing circuit 80 can generate a depth image and output it via the MIPI 79.

Fig. 8 is a flowchart showing an example of the feedback control operation of the light-receiving element 41 according to the present technology.

First, the threshold of the temperature difference between the circuit regions 15_1 and 15_2 is set (S10). That is, the allowable range of temperature variations between the circuit regions 15_1 and 15_2 is set. The threshold setting may be input by the operator via a user interface (not shown). As will be described later, when the temperature difference between the circuit regions 15_1 and 15_2 does not exceed the threshold, the bias control circuits LDO1 and LDO2 apply the same bias voltages VSPAD and VEX to the readout circuit region 15 without changing the voltages. On the other hand, when the temperature difference between the circuit regions 15_1 and 15_2 exceeds the threshold, the bias control circuits LDO1 and LDO2 adjust the bias voltages VSPAD and VEX applied to the circuit regions 15_1 and 15_2.

Next, the light-receiving element 41 performs a photon detection operation (S20). The photon detection operation is as described with reference to Fig. 7.

During the photon detection operation, the thermometers Temp1 and Temp2 measure the temperatures of the circuit regions 15_1 and 15_2 and calculate the temperature difference (S30). As a result, the thermometers Temp1 and Temp2 calculate the temperature variations between the circuit regions 15_1 and 15_2. This temperature variation calculation may be performed by a logic circuit (not shown) other than the thermometers Temp 1 and Temp2. In addition, the temperature information of the circuit regions 15_1 and 15_2 may be output to an external device of the light-receiving element 41 (for example, the control unit 42 in Fig. 1). In this case, for example, the control unit 42 calculates the temperature difference between the circuit regions 15_1 and 15_2 measured by the thermometers Temp1 and Temp2. The calculated temperature difference is input to the light-receiving element 41. The bias control circuits LDO1 and LDO2 control the bias voltages VSPAD and VEX according to this temperature difference, as will be described later.

For example, if the temperature difference does not exceed the threshold set in step S10 (NO in S40), the bias control circuits LDO1 and LDO2 apply the same bias voltages VSPAD and VEX without changing the bias voltages VSPAD and VEX. The SPAD 282 then continues to detect photons.

On the other hand, if the temperature difference exceeds the threshold set in step S10 (YES in S40), the bias control circuits LDO1 and LDO2 change the bias voltages VSPAD and VEX. That is, the bias control circuit LDO1 or LDO2 changes the reverse bias voltage ( | VBD | + | VEX |) applied to the circuit region 15_1 or 15_2.

For example, the SPAD 282 is more susceptible to avalanche breakdown at higher temperatures. Therefore, when the temperature of the circuit region 15_1 becomes higher than the temperature of the circuit region 15_2 by a threshold or more, the breakdown voltage VBD of the SPAD 282 of the pixel region 14 corresponding to the circuit region 15_1 decreases. In this case, the bias control circuit LDO1 changes the bias voltage VSPAD to match the breakdown voltage VBD of the SPAD 282 corresponding to the circuit region 15_1. As a result, the circuit region 15_1 decreases the reverse bias voltage ( | VBD | + | VEX | ) as the first voltage applied to the SPAD 282 corresponding thereto. The circuit region 15_2 may not change the reverse bias voltage ( | VBD | + | VEX | ) applied to the SPAD 282 corresponding thereto. As a result, malfunction of the SPAD 282 and erroneous detection of photons can be suppressed in the pixel region 14 corresponding to the circuit region 15_1, and the photon detective effect (PDE) of the entire light-receiving element 41 can be maintained.

On the other hand, for example, when the temperature of the circuit region 15_2 becomes higher than the temperature of the circuit region 15_1 by a threshold or more, the breakdown voltage VBD of the SPAD 282 of the pixel region 14 corresponding to the circuit region 15_2 decreases. In this case, the bias control circuit LDO2 changes the bias voltage VSPAD to match the breakdown voltage VBD of the SPAD 282 corresponding to the circuit region 15_2. As a result, the circuit region 15_2 decreases the reverse bias voltage ( | VBD | + | VEX |) as the second voltage applied to the SPAD 282 corresponding thereto. The circuit region 15_1 may not change the reverse bias voltage ( | VBD | + | VEX | ) applied to the SPAD 282 corresponding thereto. As a result, malfunction of the SPAD 282 and erroneous detection of photons can be suppressed in the pixel region 14 corresponding to the circuit region 15_2, and the photon detective effect (PDE) of the entire light-receiving element 41 can be maintained.

For example, when the light-receiving element 41 is a vehicle-mounted dToF, the distance between the light-receiving element 41 and the detection target varies greatly in a specific part of the pixel region 14 (for example, roads and buildings in the lower half) and may not change much in other parts (for example, the sky in the upper half). In such a case, the temperature of the lower-half circuit region 15_1 of the readout circuit region 15 may become extremely higher than the temperature of the upper-half circuit region 15_2. In such a case, the bias control circuit LDO1 decreases the bias voltage VSPAD according to the temperature difference between the circuit regions 15_1 and 15_2. As a result, the photon detective effect (PDE) of the entire light-receiving element 41 can be maintained.

Note that the relationship between the temperature and the breakdown voltage VBD of the SPAD 282 may be measured in advance, or is known in advance from the structure of the SPAD 282. Therefore, the relational expression between the temperature and the breakdown voltage VBD may be stored in advance in the memory (not shown) within the light-receiving element 41 or within the control unit 42.

Steps S20 to S50 are repeatedly executed until photon detection ends (NO in S60). When photon detection ends (YES in S60), photon detection by the light-receiving element 41 ends.

As described above, the light-receiving element 41 according to the present technology includes the plurality of thermometers Temp 1 and Temp2 corresponding to the plurality of circuit regions 15_1 and 15_2 of the readout circuit region 15. The temperature distribution of the readout circuit region 15 can be obtained from the plurality of thermometers Temp 1 and Temp2. The bias control circuits LDO1 and LDO2 feedback-control the bias voltages VSPAD and VEX input from the pads PAD1 and PAD2 so that the bias voltages VSPAD and VEX corresponding to the temperature distribution (temperature variation) of the readout circuit region 15 are applied to the pixel region 14 corresponding to the circuit regions 15_1 and 15_2. Thus, the light-receiving element 41 can apply different reverse bias voltages ( | VBD | + | VEX |) to the circuit regions 15_1 and 15_2, thereby compensating for variations in the breakdown voltage VBD of the SPAD 282 due to temperature variations and improving the photon detective effect (PDE). That is, the light-receiving element 41 according to the present technology can suppress variations in electrical characteristics of the pixel region 14 and improve photon detective effect (PDE) even if there is a temperature gradient in the readout circuit region 15.

In the present embodiment, two thermometers Temp 1 and Temp2 are arranged along the long side of one readout circuit region 15. Two bias control circuits LDO1 and LDO2 are arranged along the long side of one readout circuit region 15. However, the number and arrangement of thermometers and bias control circuits are not limited to this. For example, three or more thermometers and three or more bias control circuits may be arranged along the long side of one readout circuit region 15. In this case, the number of thermometers and the number of bias control circuits may be equal. In this way, it is possible to obtain a more detailed temperature distribution (temperature variation) in the readout circuit region 15, and accordingly, it is possible to set the bias voltage more finely.

For example, in the example of the vehicle-mounted dToF, many thermometers may be arranged along the lower-half circuit region 15_1 where the distance changes rapidly. A small number of thermometers may be arranged in the upper-half circuit region 15_2 where the distance changes gradually. As a result, a more detailed temperature distribution (temperature variation) of the circuit region 15_1 can be obtained, and accordingly, the bias voltage applied to the pixel region 14 corresponding to the circuit region 15_1 can be set more finely. As a result, the photon detective effect (PDE) of the entire light-receiving element 41 can be maintained even better.

### (Scan mode)

Fig. 9A is a schematic diagram showing a configuration example of a ranging system 500 operating in a scan mode. The ranging system 500 includes a light-receiving element 41, a laser diode 510, a condenser lens 520, a half mirror 530, a polygon mirror 540, a light-receiving lens 545, a drive unit 550 and a control unit 560.

The laser diode 510 generates laser light Le. The condenser lens 520 condenses the laser light Le and irradiates the half mirror 530 with the laser light Le. The half mirror 530 reflects laser light Le to the polygon mirror 540. The polygon mirror 540 irradiates the scanning region SR of the scanning area AR as the detection target range with the laser light Le. The scanning region SR is a part of the entire scanning area AR, and the entire scanning area AR can be scanned by the operation of the polygon mirror 540. The polygon mirror 540 is operated by the drive unit 550.

The reflected light Lr from the scanning region SR, of the laser light Le passes through the half mirror 530 from the polygon mirror 540 and is emitted to the pixel region 14 of the light-receiving element 41 via the light-receiving lens 545. As a result, the light-receiving element 41 detects the reflected light Lr from the scanning region SR and generates a depth image. The control unit 560 controls the entire ranging system 500.

For example, the pixel region 14 and the readout circuit region 15 of the light-receiving element 41 have an elongated shape, and ranging is performed using the reflected light Lr obtained by scanning with the laser light Le in the direction of the short side or the short diameter of the elongated shape. At this time, the scanning region SR may be, for example, a vertically elongated region extending from the ground to the sky. In this case, the light-receiving element 41 detects the vertically elongated scanning region SR at once. For example, the light-receiving element 41 detects the reflected light Lr of the scanning region SR from the ground to the sky all at once. In the scan mode, the light-receiving element 41 images only the scanning region SR at a time, but can image the entire scanning area AR by scanning the scanning region SR in the horizontal direction. Thus, the ranging system 500 can obtain a depth image of the object OBJ in the scan mode.

### (Array mode)

Fig. 9B is a schematic diagram showing a configuration example of a ranging system 600 operating in an array mode. The ranging system 600 includes a light-receiving element 41, a laser diode 610, an irradiation lens 620 and a light-receiving lens 645.

The laser diode 610 generates laser light Le. The irradiation lens 620 irradiates the entire scanning area AR with the laser light Le.

The reflected light Lr from the detection target range AR, of the laser light is irradiated onto the pixel region 14 of the light-receiving element 41 via the light-receiving lens 645. As a result, the light-receiving element 41 detects the reflected light Lr from the detection target range AR and generates a depth image.

In the array mode, the light-receiving element 41 can detect the entire detection target range AR at once and measure the distance. Thus, in the array mode, the ranging system 600 can obtain depth images of the object OBJ in a short period of time.

The light-receiving element 41 according to the present technology may be used in either the scan-mode ranging system 500 or the array-mode ranging system 600.

### <Application to Mobile Object>

The technology of the present disclosure (the present technology) can be applied to various products. For example, the technique according to the present disclosure may be realized as a device mounted on any type of moving body such as an automobile, an electric automobile, a hybrid electric automobile, a motorcycle, a bicycle, a personal mobility device, an airplane, a drone, a ship, a robot, or the like.

Fig. 10 is a block diagram showing a schematic configuration example of a vehicle control system, which is an example of a mobile object control system to which the technique according to the present disclosure can be applied.

The vehicle control system 12000 includes a plurality of electronic control units connected to each other via a communication network 12001. In the example illustrated in Fig. 10, the vehicle control system 12000 includes a drive system control unit 12010, a body system control unit 12020, a vehicle exterior information detection unit 12030, a vehicle interior information detection unit 12040, and an integrated control unit 12050. As a functional configuration of the integrated control unit 12050, a microcomputer 12051, a sound/image output unit 12052, and an in-vehicle network I/F (interface) 12053 are illustrated.

The drive system control unit 12010 controls an operation of an apparatus related to a drive system of a vehicle according to various programs. For example, the drive system control unit 12010 functions as a driving force generation unit for generating a driving force of a vehicle such as an internal combustion engine or a driving motor, a driving force transmission mechanism for transmitting a driving force to wheels, a steering mechanism for adjusting a turning angle of a vehicle, and a control apparatus such as a braking apparatus that generates a braking force of a vehicle.

The body system control unit 12020 controls operations of various devices mounted in the vehicle body according to various programs. For example, the body system control unit 12020 functions as a control device of a keyless entry system, a smart key system, a power window device, or various lamps such as a headlamp, a back lamp, a brake lamp, a turn signal, and a fog lamp. In this case, radio waves transmitted from a portable device that substitutes for a key or signals of various switches may be input to the body system control unit 12020. The body system control unit 12020 receives inputs of the radio waves or signals and controls a door lock device, a power window device, and a lamp of the vehicle.

The vehicle exterior information detection unit 12030 detects information on the outside of the vehicle having the vehicle control system 12000 mounted thereon. For example, an imaging unit 12031 is connected to the vehicle exterior information detection unit 12030. The vehicle exterior information detection unit 12030 causes the imaging unit 12031 to capture an image of the outside of the vehicle and receives the captured image. The vehicle exterior information detection unit 12030 may perform object detection processing or distance detection processing for peoples, cars, obstacles, signs, and letters on the road on the basis of the received image.

The imaging unit 12031 is an optical sensor that receives light and outputs an electrical signal according to the amount of the received light. The imaging unit 12031 can also output the electrical signal as an image or distance measurement information. In addition, the light received by the imaging unit 12031 may be visible light or invisible light such as infrared light.

The vehicle interior information detection unit 12040 detects information on the inside of the vehicle. For example, a driver state detection unit 12041 that detects a driver's state is connected to the vehicle interior information detection unit 12040. The driver state detection unit 12041 includes, for example, a camera that captures an image of a driver, and the vehicle interior information detection unit 12040 may calculate a degree of fatigue or concentration of the driver or may determine whether or not the driver is dozing on the basis of detection information input from the driver state detection unit 12041.

The microcomputer 12051 can calculate control target values for the driving force generation device, the steering mechanism, or the braking device based on the information on the inside and outside of the vehicle acquired by the vehicle exterior information detection unit 12030 or the vehicle interior information detection unit 12040, and output control commands to the drive system control unit 12010. For example, the microcomputer 12051 can perform cooperative control for the purpose of implementing functions of an advanced driver assistance system (ADAS) including vehicle collision avoidance, impact mitigation, following traveling based on an inter-vehicle distance, vehicle speed maintenance driving, vehicle collision warning, and vehicle lane deviation warning.

Further, the microcomputer 12051 can perform cooperative control for the purpose of automated driving or the like in which autonomous travel is performed without depending on operations of the driver, by controlling the driving force generation unit, the steering mechanism, or the braking device and the like on the basis of information about the surroundings of the vehicle, the information being acquired by the vehicle exterior information detection unit 12030 or the vehicle interior information detection unit 12040.

In addition, the microcomputer 12051 can output a control command to the body system control unit 12030 based on the information outside the vehicle acquired by the vehicle exterior information detection unit 12030. For example, the microcomputer 12051 can perform coordinated control for the purpose of anti-glare such as switching a high beam to a low beam by controlling a headlamp according to a position of a preceding vehicle or an oncoming vehicle detected by the vehicle exterior information detection unit 12030.

The sound/image output unit 12052 transmits an output signal of at least one of sound and an image to an output device capable of visually or audibly notifying a passenger or the outside of the vehicle of information. In the example of Fig. 10, an audio speaker 12061, a display unit 12062, and an instrument panel 12063 are illustrated as examples of the output device. The display unit 12062 may include at least one of an on-board display and a head-up display, for example.

Fig. 11 is a diagram showing an example of an installation position of the imaging unit 12031.

In Fig. 11, the imaging unit 12031 includes imaging units 12101, 12102, 12103, 12104, and 12105.

The imaging units 12101, 12102, 12103, 12104, and 12105 are provided at, for example, positions of a front nose, side mirrors, a rear bumper, a back door, an upper portion of a vehicle internal front windshield, and the like of the vehicle 12100. The imaging unit 12101 provided on a front nose and the imaging unit 12105 provided in an upper portion of the vehicle internal front windshield mainly acquire images in front of the vehicle 12100. The imaging units 12102 and 12103 provided in the side mirrors mainly acquire images on the lateral sides of the vehicle 12100. The imaging unit 12104 included in the rear bumper or the back door mainly acquires an image of an area behind the vehicle 12100. The imaging unit 12105 included in the upper portion of the windshield inside the vehicle is mainly used for detection of a preceding vehicle, a pedestrian, an obstacle, a traffic signal, a traffic sign, a lane, or the like.

Fig. 11 shows an example of imaging ranges of the imaging units 12101 to 12104. An imaging range 12111 indicates an imaging range of the imaging unit 12101 provided at the front nose, imaging ranges 12112 and 12113 respectively indicate the imaging ranges of the imaging units 12102 and 12103 provided at the side-view mirrors, and an imaging range 12114 indicates the imaging range of the imaging unit 12104 provided at the rear bumper or the back door. For example, by superimposing image data captured by the imaging units 12101 to 12104, it is possible to obtain a bird's-eye view image viewed from the upper side of the vehicle 12100.

At least one of the imaging units 12101 to 12104 may have a function for obtaining distance information. For example, at least one of the imaging units 12101 to 12104 may be a stereo camera constituted by a plurality of imaging elements or may be an imaging element that has pixels for phase difference detection.

For example, the microcomputer 12051 can extract, particularly, a closest three-dimensional object on a path through which the vehicle 12100 is traveling, which is a three-dimensional object traveling at a predetermined speed (for example, 0 km/h or higher) in the substantially same direction as the vehicle 12100, as a preceding vehicle by acquiring a distance to each three-dimensional object in the imaging ranges 12111 to 12114 and temporal change in the distance (a relative speed with respect to the vehicle 12100) on the basis of distance information obtained from the imaging units 12101 to 12104. The microcomputer 12051 can also set an inter-vehicle distance to the preceding vehicle to be secured in advance and perform automatic brake control (including following stop control) and automatic acceleration control (including following start control). Thus, it is possible to perform cooperative control for the purpose of, for example, automated driving in which the vehicle travels in an automated manner without requiring the driver to perform operations.

For example, the microcomputer 12051 can classify and extract three-dimensional data regarding three-dimensional objects into two-wheeled vehicles, normal vehicles, large vehicles, pedestrians, and other three-dimensional objects such as electric poles based on distance information obtained from the imaging units 12101 to 12104 and can use the three-dimensional data to perform automated avoidance of obstacles. For example, the microcomputer 12051 differentiates surrounding obstacles of the vehicle 12100 into obstacles which can be viewed by the driver of the vehicle 12100 and obstacles which are difficult to view. Then, the microcomputer 12051 determines a collision risk indicating the degree of risk of collision with each obstacle, and when the collision risk is equal to or higher than a set value and there is a possibility of collision, an alarm is output to the driver through the audio speaker 12061 or the display unit 12062, forced deceleration or avoidance steering is performed through the drive system control unit 12010, and thus it is possible to perform driving support for collision avoidance.

At least one of the imaging units 12101 to 12104 may be an infrared camera that detects infrared rays. For example, the microcomputer 12051 can recognize a pedestrian by determining whether there is a pedestrian in the captured image of the imaging units 12101 to 12104. Such pedestrian recognition is performed by, for example, a procedure in which feature points in the captured images of the imaging units 12101 to 12104 as infrared cameras are extracted and a procedure in which pattern matching processing is performed on a series of feature points indicating an outline of an object to determine whether or not the object is a pedestrian. When the microcomputer 12051 determines that there is a pedestrian in the captured images of the imaging units 12101 to 12104 and the pedestrian is recognized, the sound/image output unit 12052 controls the display unit 12062 so that a square contour line for emphasis is superimposed and displayed with the recognized pedestrian. In addition, the sound/image output unit 12052 may control the display unit 12062 so that an icon indicating a pedestrian or the like is displayed at a desired position.

An example of the vehicle control system to which the technology according to the present disclosure can be applied has been described above. The technology according to the present disclosure can be applied, for example, to each imaging unit 12031 among the components described above.

### [Reference Signs List]

- 41: Light-receiving element
- CH1: First chip
- CH2: Second chip
- 14: Pixel region
- 15: Readout circuit region
- 280: Pixel circuit
- 290: Readout circuit
- 70: Peripheral circuit
- 71: Pixel circuit region
- 80: Signal processing unit
- 79: Transmitting unit
- 281: Resistance element
- 282: SPAD
- 283: Inverter circuit
- 284: Transistor
- 285: Bonding portion
- 80: Signal processing circuit
- 74: PLL
- 79: Transmitting unit
- 296: PoR circuit
- Temp1, Temp2: Thermometer
- Bias1, Bias2: Bias circuit
- LDO1, LDO2: Bias control circuit

## Claims

1. A light-receiving element (41) comprising:
a pixel region (14) in which a plurality of photodiodes (282) is arranged;
a readout circuit region (15) including a plurality of readout circuits (290) provided corresponding to the plurality of photodiodes (282), respectively;
a first thermometer (Temp1) provided corresponding to a first circuit region (15_1) of the readout circuit region (15);
a second thermometer (Temp2) provided corresponding to a second circuit region (15_2) of the readout circuit region (15);
a first control circuit (LDO1), configured to apply a first voltage corresponding to a temperature of the first circuit region (15_1) measured by the first thermometer (Temp1) to the photodiode (282) corresponding to the readout circuit (290) in the first circuit region (15_1);
a second control circuit (LDO2), configured to apply a second voltage corresponding to a temperature of the second circuit region (15_2) measured by the second thermometer (Temp2) to the photodiode (282) corresponding to the readout circuit (290) in the second circuit region (15_2);
**characterized by** further comprising
a first chip (CH1) including the pixel region (14); and
a second chip (CH2) including the readout circuit region (15) and bonded by stacking to the first chip (CH1) so that the readout circuits (290) correspond on a one-to-one basis to the photodiodes (282).

2. The light-receiving element (41) according to claim 1, wherein
the readout circuit region (15) has an elongated shape with a long side or a long diameter, and includes the first and second circuit regions (15_1, 15_2) arranged along the long side or the long diameter, and the first and second thermometers (Temp1, Temp2) are arranged corresponding to the first and second circuit regions (15_1, 15_2) along the long side or the long diameter.

3. The light-receiving element (41) according to claim 1 or 2, further comprising: a signal processing circuit (80) provided adjacent to one side of the readout circuit region (15) and configured to process pixel signals from the readout circuit region (15), wherein the first and second thermometers (Temp1, Temp2) are provided on a side opposite to the signal processing circuit (80) across the readout circuit region (15).

4. The light-receiving element (41) according to claim 3, further comprising:
a first pad (PAD1) connected to the first control circuit (LDO1); and
a second pad (PAD2) connected to the second control circuit (LDO2), wherein
the first thermometer (Temp1) is arranged between the first circuit region (15_1) and the first pad (PAD1), and
the second thermometer (Temp2) is arranged between the second circuit region (15_2) and the second pad (PAD2).

5. The light-receiving element (41) according to any one of claims 1 to 4, further comprising
a first bias circuit (Bias1) provided corresponding to the first circuit region (15_1) and configured to supply power to a driver of the readout circuit region (15); and
a second bias circuit (Bias2) provided corresponding to the second circuit region (15_2) and configured to supply power to a driver of the readout circuit region (15).

6. The light-receiving element (41) according to claim 5, further comprising:
a signal processing circuit (80) provided adjacent to one side of the readout circuit region (15) and configured to process pixel signals from the readout circuit region (15), wherein the first and second bias circuits (Bias1, Bias2) are provided on a side opposite to the signal processing circuit (80) across the readout circuit region (15).

7. The light-receiving element (41) according to claim 5 or 6, further comprising:
a first pad (PAD1) connected to the first control circuit (LDO1); and
a second pad (PAD2) connected to the second control circuit (LDO2), wherein
the first bias circuit (Bias1) is arranged between the first circuit region (15_1) and the first pad (PAD1), and
the second bias circuit (Bias2) is arranged between the second circuit region (15_2) and the second pad (PAD2).

8. The light-receiving element (41) according to any one of claims 5 to 7, wherein
the first bias circuit (Bias1) is arranged close to the first thermometer (Temp1), and
the second bias circuit (Bias2) is arranged close to the second thermometer (Temp2).

9. The light-receiving element (41) according to claim 8, wherein
the pixel region (14) has an elongated shape similar to the readout circuit region (15), and contacts the readout circuit region (15) when the first chip (CH1) and the second chip (CH2) are bonded.

10. The light-receiving element (41) according to any one of claims 1 to 9, wherein
the first or second control circuit (LDO1, LDO2) is configured to change an absolute value of the first or second voltage when a difference between the temperature of the first circuit region (15_1) and the temperature of the second circuit region (15_2) exceeds a first threshold.

11. The light-receiving element (41) according to claim 10, wherein
the first control circuit (LDO1) is configured to decrease the absolute value of the first voltage when the temperature of the first circuit region (15_1) is higher than the temperature of the second circuit region (15_2), and
the second control circuit (LDO2) is configured to decrease the absolute value of the second voltage when the temperature of the second circuit region (15_2) is higher than the temperature of the first circuit region (15_1).

12. The light-receiving element (41) according to any one of claims 1 to 11, wherein the light-receiving element (41) is mounted on an automobile.

13. A ranging system (11, 500, 600) comprising:
an illumination device (21), configured to irradiate an object with irradiation light; and
a light-receiving element (41) according to any one of claims 1 to 12, further configured to receive reflected light from the object irradiated with the irradiation light.

14. The ranging system (11, 500, 600) according to claim 13, wherein
the pixel region (14) and the readout circuit region (15) each have an elongated shape having a long side or a long diameter, and ranging is performed using the reflected light obtained by scanning a detection target range in a direction of a short side or a short diameter of the elongated shape; or wherein
the pixel region (14) and the readout circuit region (15) are configured to detect an entire detection target range at once to perform ranging.

15. The ranging system (11, 500, 600) according to claim 13, wherein
the first or second control circuit (LDO1, LDO2) is configured to change an absolute value of the first or second voltage when a difference between the temperature of the first circuit region (15_1) and the temperature of the second circuit region (15_2) exceeds a first threshold, wherein the first control circuit (LDO1) is configured to decrease the absolute value of the first voltage when the temperature of the first circuit region (15_1) is higher than the temperature of the second circuit region (15_2), and the second control circuit (LDO2) is configured to decrease the absolute value of the second voltage when the temperature of the second circuit region (15_2) is higher than the temperature of the first circuit region (15_1).

## Patentansprüche

1. Lichtempfangselement (41), umfassend:
einen Pixelbereich (14), in dem eine Vielzahl von Fotodioden (282) angeordnet ist;
einen Ausleseschaltungsbereich (15), einschließlich einer Vielzahl von Ausleseschaltungen (290), die jeweils entsprechend der Vielzahl von Fotodioden (282) bereitgestellt sind;
ein erstes Thermometer (Temp1), das entsprechend einem ersten Schaltungsbereich (15_1) des Ausleseschaltungsbereichs (15) bereitgestellt ist;
ein zweites Thermometer (Temp2), das entsprechend einem zweiten Schaltungsbereich (15_2) des Ausleseschaltungsbereichs (15) bereitgestellt ist;
eine erste Steuerschaltung (LDO1), die konfiguriert ist, um eine erste Spannung, die einer durch das erste Thermometer (Temp1) gemessenen Temperatur des ersten Schaltungsbereichs (15_1) entspricht, an die Fotodiode (282) anzulegen, die der Ausleseschaltung (290) in dem ersten Schaltungsbereich (15_1) entspricht;
eine zweite Steuerschaltung (LDO2), die konfiguriert ist, um eine zweite Spannung, die einer durch das zweite Thermometer (Temp2) gemessenen Temperatur des zweiten Schaltungsbereichs (15_2) entspricht, an die Fotodiode (282) anzulegen, die der Ausleseschaltung (290) in dem zweiten Schaltungsbereich (15_2) entspricht;
**dadurch gekennzeichnet, dass** es ferner umfasst
einen ersten Chip (CH1), der den Pixelbereich (14) einschließt; und
einen zweiten Chip (CH2), der den Ausleseschaltungsbereich (15) einschließt und durch Stapeln mit dem ersten Chip (CH1) gebondet ist, sodass die Ausleseschaltungen (290) den Fotodioden (282) eins zu eins entsprechen.

2. Lichtempfangselement (41) nach Anspruch 1, wobei
der Ausleseschaltungsbereich (15) eine längliche Form mit einer langen Seite oder einem langen Durchmesser aufweist und den ersten und zweiten Schaltungsbereich (15_1, 15_2) einschließt, die entlang der langen Seite oder des langen Durchmessers angeordnet sind, und das erste und zweite Thermometer (Temp1, Temp2) entsprechend dem ersten und zweiten Schaltungsbereich (15_1, 15_2) entlang der langen Seite oder des langen Durchmessers angeordnet sind.

3. Lichtempfangselement (41) nach Anspruch 1 oder 2, ferner umfassend:
eine Signalverarbeitungsschaltung (80), die angrenzend an eine Seite des Ausleseschaltungsbereichs (15) bereitgestellt ist und konfiguriert ist, um Pixelsignale aus dem Ausleseschaltungsbereich (15) zu verarbeiten, wobei das erste und das zweite Thermometer (Temp1, Temp2) auf einer der Signalverarbeitungsschaltung (80) über den Ausleseschaltungsbereich (15) hinweg gegenüberliegenden Seite bereitgestellt sind.

4. Lichtempfangselement (41) nach Anspruch 3, ferner umfassend:
ein erstes Pad (PAD1), das mit der ersten Steuerschaltung (LDO1) verbunden ist; und
ein zweites Pad (PAD2), das mit der zweiten Steuerschaltung (LDO2) verbunden ist, wobei
das erste Thermometer (Temp1) zwischen dem ersten Schaltungsbereich (15_1) und dem ersten Pad (PAD1) angeordnet ist, und
das zweite Thermometer (Temp2) zwischen dem zweiten Schaltungsbereich (15_2) und dem zweiten Pad (PAD2) angeordnet ist.

5. Lichtempfangselement (41) nach einem der Ansprüche 1 bis 4, ferner umfassend
eine erste Vorspannungsschaltung (Bias1), die entsprechend dem ersten Schaltungsbereich (15_1) bereitgestellt und konfiguriert ist, um einem Treiber des Ausleseschaltungsbereichs (15) Leistung zuzuführen; und
eine zweite Vorspannungsschaltung (Bias2), die entsprechend dem zweiten Schaltungsbereich (15_2) bereitgestellt und konfiguriert ist, um einem Treiber des Ausleseschaltungsbereichs (15) Leistung zuzuführen;

6. Lichtempfangselement (41) nach Anspruch 5, ferner umfassend:
eine Signalverarbeitungsschaltung (80), die angrenzend an eine Seite des Ausleseschaltungsbereichs (15) bereitgestellt ist und konfiguriert ist, um Pixelsignale aus dem Ausleseschaltungsbereich (15) zu verarbeiten, wobei die erste und die zweite Vorspannungsschaltung (Bias1, Bias2) auf einer der Signalverarbeitungsschaltung (80) über den Ausleseschaltungsbereich (15) hinweg gegenüberliegenden Seite bereitgestellt sind.

7. Lichtempfangselement (41) nach Anspruch 5 oder 6, ferner umfassend:
ein erstes Pad (PAD1), das mit der ersten Steuerschaltung (LDO1) verbunden ist; und
ein zweites Pad (PAD2), das mit der zweiten Steuerschaltung (LDO2) verbunden ist, wobei
die erste Vorspannungsschaltung (Bias1) zwischen dem ersten Schaltungsbereich (15_1) und dem ersten Pad (PAD1) angeordnet ist, und
die zweite Vorspannungsschaltung (Bias2) zwischen dem zweiten Schaltungsbereich (15_2) und dem zweiten Pad (PAD2) angeordnet ist.

8. Lichtempfangselement (41) nach einem der Ansprüche 5 bis 7, wobei
die erste Vorspannungsschaltung (Bias1) nahe dem ersten Thermometer (Temp1) angeordnet ist, und die zweite Vorspannungsschaltung (Bias2) nahe dem zweiten Thermometer (Temp2) angeordnet ist.

9. Lichtempfangselement (41) nach Anspruch 8, wobei
der Pixelbereich (14) eine längliche Form ähnlich dem Ausleseschaltungsbereich (15) aufweist und mit dem Ausleseschaltungsbereich (15) in Kontakt tritt, wenn der erste Chip (CH1) und der zweite Chip (CH2) gebondet sind.

10. Lichtempfangselement (41) nach einem der Ansprüche 1 bis 9, wobei
die erste oder zweite Steuerschaltung (LDO1, LDO2) konfiguriert ist, um einen Absolutwert der ersten oder zweiten Spannung zu ändern, wenn eine Differenz zwischen der Temperatur des ersten Schaltungsbereichs (15_1) und der Temperatur des zweiten Schaltungsbereichs (15_2) einen ersten Schwellenwert überschreitet.

11. Lichtempfangselement (41) nach Anspruch 10, wobei
die erste Steuerschaltung (LDO1) konfiguriert ist, um den absoluten Wert der ersten Spannung zu verringern, wenn die Temperatur des ersten Schaltungsbereichs (15_1) höher als die Temperatur des zweiten Schaltungsbereichs (15_2) ist, und
die zweite Steuerschaltung (LDO2) konfiguriert ist, um den absoluten Wert der zweiten Spannung zu verringern, wenn die Temperatur des zweiten Schaltungsbereichs (15_2) höher ist als die Temperatur des ersten Schaltungsbereichs (15_1).

12. Lichtempfangselement (41) nach einem der Ansprüche 1 bis 11, wobei das Lichtempfangselement (41) an einem Automobil montiert ist.

13. Entfernungsmesssystem (11, 500, 600), umfassend:
eine Beleuchtungseinrichtung (21), die konfiguriert ist, um ein Objekt mit Bestrahlungslicht zu bestrahlen; und
ein Lichtempfangselement (41) nach einem der Ansprüche 1 bis 12, das ferner konfiguriert ist, um reflektiertes Licht von dem mit dem Bestrahlungslicht bestrahlten Objekt zu empfangen.

14. Entfernungsmesssystem (11, 500, 600) nach Anspruch 13, wobei
der Pixelbereich (14) und der Ausleseschaltungsbereich (15) jeweils eine längliche Form mit einer langen Seite oder einem langen Durchmesser aufweisen, und eine Entfernungsmessung unter Verwendung des reflektierten Lichts durchgeführt wird, das durch Abtasten eines Erfassungszielbereichs in einer Richtung einer kurzen Seite oder eines kurzen Durchmessers der länglichen Form erhalten wird; oder wobei
der Pixelbereich (14) und der Ausleseschaltungsbereich (15) konfiguriert sind, um einen gesamten Erfassungszielbereich auf einmal zu erfassen, um eine Entfernungsmessung durchzuführen.

15. Entfernungsmesssystem (11, 500, 600) nach Anspruch 13, wobei
die erste oder zweite Steuerschaltung (LDO1, LDO2) konfiguriert ist, um einen absoluten Wert der ersten oder zweiten Spannung zu ändern, wenn eine Differenz zwischen der Temperatur der ersten Schaltungsregion (15_1) und der Temperatur der zweiten Schaltungsregion (15_2) einen ersten Schwellenwert überschreitet, wobei die erste Steuerschaltung (LDO1) konfiguriert ist, um den absoluten Wert der ersten Spannung zu verringern, wenn die Temperatur der ersten Schaltungsregion (15_1) höher als die Temperatur der zweiten Schaltungsregion (15_2) ist, und die zweite Steuerschaltung (LDO2) konfiguriert ist, um den absoluten Wert der zweiten Spannung zu verringern, wenn die Temperatur der zweiten Schaltungsregion (15_2) höher als die Temperatur der ersten Schaltungsregion (15_1) ist.

## Revendications

1. Élément de réception de lumière (41) comprenant :
une région de pixels (14) dans laquelle sont disposées une pluralité de photodiodes (282) ;
une région de circuit de lecture (15) comportant une pluralité de circuits de lecture (290) prévus en correspondance avec la pluralité de photodiodes (282), respectivement ;
un premier thermomètre (Temp1) prévu en correspondance avec une première région de circuit (15_1) de la région de circuit de lecture (15) ;
un second thermomètre (Temp2) prévu en correspondance avec une seconde région de circuit (15_2) de la région de circuit de lecture (15) ;
un premier circuit de commande (LDO1), configuré pour appliquer une première tension correspondant à une température de la première région de circuit (15_1), mesurée par le premier thermomètre (Temp1), à la photodiode (282) correspondant au circuit de lecture (290) dans la première région de circuit (15_1) ;
un second circuit de commande (LDO2), configuré pour appliquer une seconde tension correspondant à une température de la seconde région de circuit (15_2), mesurée par le second thermomètre (Temp2), à la photodiode (282) correspondant au circuit de lecture (290) dans la seconde région de circuit (15_2) ;
et **caractérisé en ce qu'**il comprend en outre
une première puce (CH1) comportant la région de pixels (14) ; et
une seconde puce (CH2) comportant la région de circuit de lecture (15) et liée par empilement à la première puce (CH1) de sorte que les circuits de lecture (290) correspondent, sur une base individuelle, aux photodiodes (282).

2. Élément de réception de lumière (41) selon la revendication 1, dans lequel
la région de circuit de lecture (15) a une forme allongée avec un grand côté ou un grand diamètre, et comporte les première et seconde régions de circuit (15_1, 15_2) disposées le long du grand côté ou du grand diamètre, et les premier et second thermomètres (Temp1, Temp2) sont disposés en correspondance avec les première et seconde régions de circuit (15_1, 15_2) le long du grand côté ou du grand diamètre.

3. Élément de réception de lumière (41) selon la revendication 1 ou 2, comprenant en outre :
un circuit de traitement de signal (80) prévu à côté d'un côté de la région de circuit de lecture (15) et configuré pour traiter des signaux de pixel à partir de la région de circuit de lecture (15), dans lequel les premier et second thermomètres (Temp1, Temp2) sont prévus d'un côté opposé au circuit de traitement de signal (80), de l'autre côté de la région de circuit de lecture (15).

4. Élément de réception de lumière (41) selon la revendication 3, comprenant en outre :
une première pastille (PAD1) connectée au premier circuit de commande (LDO1) ; et
une seconde pastille (PAD2) connectée au second circuit de commande (LDO2), dans lequel
le premier thermomètre (Temp1) est disposé entre la première région de circuit (15_1) et la première pastille (PAD1), et
le second thermomètre (Temp2) est disposé entre la seconde région de circuit (15_2) et la seconde pastille (PAD2).

5. Élément de réception de lumière (41) selon l'une quelconque des revendications 1 à 4, comprenant en outre :
un premier circuit de polarisation (Bias1) prévu en correspondance avec la première région de circuit (15_1) et configuré pour alimenter un circuit d'attaque de la région de circuit de lecture (15) ; et
un second circuit de polarisation (Bias2) prévu en correspondance avec la seconde région de circuit (15_2) et configuré pour alimenter un circuit d'attaque de la région de circuit de lecture (15).

6. Élément de réception de lumière (41) selon la revendication 5, comprenant en outre :
un circuit de traitement de signal (80) prévu à côté d'un côté de la région de circuit de lecture (15) et configuré pour traiter des signaux de pixel à partir de la région de circuit de lecture (15), dans lequel les premier et second circuits de polarisation (Bias1, Bias2) sont prévus d'un côté opposé au circuit de traitement de signal (80), de l'autre côté de la région de circuit de lecture (15).

7. Élément de réception de lumière (41) selon la revendication 5 ou 6, comprenant en outre :
une première pastille (PAD1) connectée au premier circuit de commande (LDO1) ; et
une seconde pastille (PAD2) connectée au second circuit de commande (LDO2), dans lequel
le premier circuit de polarisation (Bias1) est disposé entre la première région de circuit (15_1) et la première pastille (PAD1), et
le second circuit de polarisation (Bias2) est disposé entre la seconde région de circuit (15_2) et la seconde pastille (PAD2).

8. Élément de réception de lumière (41) selon l'une quelconque des revendications 5 à 7, dans lequel
le premier circuit de polarisation (Bias1) est disposé à proximité du premier thermomètre (Temp1), et le second circuit de polarisation (Bias2) est disposé à proximité du second thermomètre (Temp2).

9. Élément de réception de lumière (41) selon la revendication 8, dans lequel
la région de pixels (14) a une forme allongée similaire à la région de circuit de lecture (15), et entre en contact avec la région de circuit de lecture (15) lorsque la première puce (CH1) et la seconde puce (CH2) sont liées.

10. Élément de réception de lumière (41) selon l'une quelconque des revendications 1 à 9, dans lequel
le premier ou second circuit de commande (LDO1, LDO2) est configuré pour modifier une valeur absolue de la première ou seconde tension lorsqu'une différence entre la température de la première région de circuit (15_1) et la température de la seconde région de circuit (15_2) dépasse un premier seuil.

11. Élément de réception de lumière (41) selon la revendication 10, dans lequel
le premier circuit de commande (LDO1) est configuré pour diminuer la valeur absolue de la première tension lorsque la température de la première région de circuit (15_1) est supérieure à la température de la seconde région de circuit (15_2), et
le second circuit de commande (LDO2) est configuré pour diminuer la valeur absolue de la seconde tension lorsque la température de la seconde région de circuit (15_2) est supérieure à la température de la première région de circuit (15_1).

12. Élément de réception de lumière (41) selon l'une quelconque des revendications 1 à 11, dans lequel l'élément de réception de lumière (41) est monté sur une automobile.

13. Système de télémétrie (11, 500, 600) comprenant :
un dispositif d'éclairage (21), configuré pour irradier un objet avec de la lumière d'irradiation ; et
un élément de réception de lumière (41) selon l'une quelconque des revendications 1 à 12, configuré en outre pour recevoir de la lumière réfléchie par l'objet irradié avec la lumière d'irradiation.

14. Système de télémétrie (11, 500, 600) selon la revendication 13, dans lequel
la région de pixels (14) et la région de circuit de lecture (15) ont chacune une forme allongée ayant un grand côté ou un grand diamètre, et la télémétrie est effectuée à l'aide de la lumière réfléchie obtenue par balayage d'une plage cible de détection dans une direction d'un petit côté ou d'un petit diamètre de la forme allongée ; ou dans lequel
la région de pixels (14) et la région de circuit de lecture (15) sont configurées pour détecter une plage cible de détection entière en une seule fois afin d'effectuer une télémétrie.

15. Système de télémétrie (11, 500, 600) selon la revendication 13, dans lequel
le premier ou second circuit de commande (LDO1, LDO2) est configuré pour modifier une valeur absolue de la première ou seconde tension lorsqu'une différence entre la température de la première région de circuit (15_1) et la température de la seconde région de circuit (15_2) dépasse un premier seuil, dans lequel le premier circuit de commande (LDO1) est configuré pour diminuer la valeur absolue de la première tension lorsque la température de la première région de circuit (15_1) est supérieure à la température de la seconde région de circuit (15_2), et le second circuit de commande (LDO2) est configuré pour diminuer la valeur absolue de la seconde tension lorsque la température de la seconde région de circuit (15_2) est supérieure à la température de la première région de circuit (15_1).
